# EUROPÄISCHE PATENTSCHRIFT

(11) **EP 1 938 396 B1**
(45) Veröffentlichungstag und Bekanntmachung des Hinweises auf die Patenterteilung: **09.01.2013**
(21) Anmeldenummer: 06806270.2
(22) Anmeldetag: 13.10.2006
(51) Int. Cl.: H01L 41/08, B81B 3/00, H05K 1/02

(54) **FLÄCHENSUBSTRAT MIT ELEKTRISCH LEITENDER STRUKTUR**
FLAT SUBSTRATE HAVING AN ELECTRICALLY CONDUCTIVE STRUCTURE
SUBSTRAT PLAT POURVU D'UNE STRUCTURE ELECTROCONDUCTRICE

(30) Priorität: 21.10.2005 DE 102005050515
(43) Veröffentlichungstag der Anmeldung: 02.07.2008
(73) Patentinhaber: Fraunhofer-Gesellschaft zur Förderung der angewandten Forschung e.V., 80686 München (DE)
(72) Erfinder: KAUFMANN, Heinz, 64732 Bad König (CH); SINDELAR, Ralf, Dr., 30459 Hannover (DE); MELZ, Tobias, 64285 Darmstadt (DE)
(74) Vertreter: Rösler, Uwe
(86) Internationale Anmeldenummer: PCT/EP2006/009927
(87) Internationale Veröffentlichungsnummer: WO 2007/045408

(56) Entgegenhaltungen:
- WO-A2-01/73937
- US-A- 4 226 507
- US-A- 4 363 991
- US-A1- 20050 046 921

## Beschreibung

### Technisches Gebiet

Die Erfindung bezieht sich auf ein Flächensubstrat mit einer innerhalb des Flächensubstrats integrierten oder an einer Oberfläche des Flächensubstrats applizierten elektrisch leitenden Struktur und/oder einer technisch vergüteten Oberfläche, bei dem wenigstens ein Sensor in dem Flächensubstrat integriert oder an einer Oberfläche des Flächensubstrates appliziert ist, der in Abhängigkeit von innerhalb des Flächensubstrats auftretenden mechanischen Spannungen Sensorsignale generiert, und bei dem wenigstens ein Aktor in dem Flächensubstrat integriert oder an der Oberfläche des Flächensubstrats appliziert ist, der bei Aktivierung das Flächensubstrat mechanisch zu deformieren vermag, wobei eine mit dem wenigstens einen Sensor und dem wenigstens einen Aktor verbundene Signaleinheit vorgesehen ist, die auf der Grundlage der Sensorsignale Aktorsignale zur Aktivierung des Aktors generiert, so dass innerhalb des Flächensubstrats auftretende Verformungen reduziert werden.

### Stand der Technik

Der steigende Bedarf an elektronischen Geräten mit verbesserter Funktionalität ist eng an die Weiterentwicklung elektronischer Baugruppen gekoppelt und trägt vor allem zu Miniaturisierung sowie zur Verbesserung der Zuverlässigkeit diesbezüglicher Vorrichtungen wesentlich bei. Dies ist auch der Grund dafür, dass sich auf dem Bereich der Leiterplatten- und Chiptechnologie ein bedeutsamer Variantenreichtum an unterschiedlichen Leiterplatten- und Chipformen ausgebildet hat.

Ein wichtiger Aspekt für die Funktionalität und Zuverlässigkeit derartiger prozessierter Flächensubstrate kommt ihrer Dimensions- und Formstabilität zu. Insbesondere unter thermisch veränderlichen Umgebungsbedingungen führt ihr Einsatz zu thermisch induzierten Spannungen und damit verbundenen geometrischen Verwindungen innerhalb des Flächensubstrats, wodurch auch auf bzw. in dem Flächensubstrat applizierte bzw. integrierte elektrische Leiterbahnabschnitte oder mikroelektronische Leiter- bzw. Prozessorarchitekturen deutlich in Mitleidenschaft gezogen werden können. Hinzukommt, dass auch fertigungsbedingte Eigenspannungen die Formtreue von Flächensubstraten beeinträchtigen können. Hier gilt es Maßnahme zu treffen,dem Auftreten derartiger mechanischer Spannungen möglichst wirksam entgegenzutreten. Zur Reduzierung derartiger Verwindungen und Verwerfungen werden in der Chiptechnologie zumeist zusätzliche Schichten auf bzw. in dem Chip vorgesehen, die thermisch weitgehend invariant sind und somit fertigungs- und einsatzbedingte Eigenspannungen aufheben sollen.

Aus der US-A-4,939,021 ist hierzu eine Mehrschichtleiterplatte zu entnehmen, die Kupferschichten und das thermische Ausdehnungsverhalten der Mehrschichtleiterplatte bestimmende, jeweils zwischen den Kupferschichten befindliche Glaskeramikschichten vorsieht.

Aus der JP 07 249847 ist ein Verfahren zur Herstellung einer Mehrschichtleiterplatte zur Bestückung mit elektronischen Bauelementen beschrieben, die aus Gründen der Stabilisierung gegenüber unterschiedlicher thermischer Ausdehnungseigenschaften der einzelnen Schichten eine Schicht aus Glasfasermaterial vorsieht, das mittels eines Epoxidharzes mit einem weiteren Schichtmaterial durch Pressen zu einem Laminat verfügt wird.

Allen bekannten Maßnahmen zur Reduzierung von Eigenspannungen und/oder thermisch induzierten Spannungen innerhalb prozessierter Flächensubstrate oder Mikrochips durch Vorsehen thermisch stabiler Materialschichten haftet der Nachteil an, dass die zusätzlichen Schichten den Gesamtaufbau der Mehrschichtsysteme vergrößern und lediglich nur in einem geringen Maße eine erwünschte Formstabilität der Trägersubstrate insbesondere bei Auftreten erhöhter Temperaturunterschiede gewährleisten.

Die US 4,363,991 beschriebt eine mit Piezosensoren und Aktoren versehene Oberfläche, die einem Fluid- bzw. Luft- oder Wasserstrom ausgesetzt ist und in Abhängigkeit der jeweiligen Fluidströmung derart aktorisch verformbar ist, so dass der Fluidwiderstand möglichst gering gehalten werden soll. Als Beispiele für eine derartige Oberfläche kommen Schiffsrumpfaußenflächen oder Flugzeugoberflächen.

Die US 2005/0046921 A1 beschreibt einen räumlichen Lichtmodulator, kurz SLM, der ein Trägersubstrat vorsieht, auf dessen einen Oberfläche eine Vielzahl stempelartig ausgebildeter Aktoren aufgebracht ist, an deren dem Substrat abgewandten Aktorende jeweils ein reflektierendes Element angebracht ist. Jeder einzelne Aktor führt bei entsprechender Aktivierung eine in Stempel-Längserstreckung orientierte Längenausdehnung bzw. Längenverkürzung aus, wodurch sich die räumliche Lage der einzelnen reflektierenden Elemente kontrolliert verändern lässt.

Die US 4,226,507 beschreibt einen Spiegel, an dessen Spiegelrückseite wenigstens drei Piezostapel in sternförmiger Anordnung angebracht sind, die durch unterschiedliche Längenänderung den Spiegel kontrolliert zu deformieren vermögen

### Darstellung der Erfindung

Der Erfindung liegt die Aufgabe zugrunde, ein Flächensubstrat mit einer innerhalb des Flächensubstrats integrierten oder an einer Oberfläche des Flächensubstrats applizierten elektrisch leitenden Struktur und/oder einer technisch vergüteten Oberfläche, bei dem wenigstens ein Sensor in dem Flächensubstrat integriert oder an einer Oberfläche des Flächensubstrates appliziert ist, der in Abhängigkeit von innerhalb des Flächensubstrats auftretenden mechanischen Spannungen Sensorsignale generiert, und bei dem wenigstens ein Aktor in dem Flächensubstrat integriert oder an der Oberfläche des Flächensubstrats appliziert ist, der bei Aktivierung das Flächensubstrat mechanisch zu deformieren vermag, wobei eine mit dem wenigstens einen Sensor und dem wenigstens einen Aktor verbundene Signaleinheit vorgesehen ist, die auf der Grundlage der Sensorsignale Aktorsignale zur Aktivierung des Aktors generiert, so dass innerhalb des Flächensubstrats auftretende Verformungen reduziert werden, derart weiterzubilden, dass herstellungs- und/oder einsatzbedingte Verformungen aufgrund auftretender mechanischen Spannungen innerhalb des Flächensubstrates weitgehend ausgeschlossen werden sollen. Die hierfür erforderlichen Maßnahmen sollen die Möglichkeit einer Regelung bieten, mit der die innerhalb des Flächensubstrats auftretenden Verformungen und Verwerfungen nachhaltig unterdrückt werden können, auch in Fällen, in denen das Flächensubstrat Veränderungen der eigenen Verformungseigenschaften unterliegt.

Die Lösung der der Erfindung zugrunde liegenden Aufgabe ist in den Ansprüchen 1 angegeben. Den Erfindungsgedanken vorteilhaft weiterbildende Merkmale sind Gegenstand der Unteransprüche sowie der Beschreibung insbesondere unter Bezugnahme auf das Ausführungsbeispiel zu entnehmen.

In Abkehr von der bisherigen Verwendung rein passiv wirkenden Schichten, die die Formstabilität von Flächensubstraten zu verbessern versuchen sieht ein lösungsgemäß ausgebildetes Flächensubstrat mit den Merkmalen des Oberbegriffes des Anspruches 1 wenigstens einen schichtförmig ausgebildeten Sensor und Aktor vor, die wenigstens in Teilbereichen aus einem multifunktionalen Material bestehen, wobei das Flächensubstrat ein Mikrochip mit ein- oder mehrlagigem Aufbau und die Signaleinheit Teil des Chips ist und die zur Signalgenerierung erforderliche Logik durch die im Chip immanente Rechenleistung abgebildet wird.

Bei dem lösungsgemäß vorgeschlagenen System handelt es sich um eine aktive Beeinflussung von eigenspannungs- oder thermospannungsbedingten Verwerfungen innerhalb des Flächensubstrates. Die auf Basis multifunktionaler Werkstoffe beruhenden Sensoren und Aktoren, die vorzugsweise schichtförmig auf einer Oberfläche des Flächensubstrates aufgebracht sind und vorzugsweise aus einer Piezokeramik bestehen, vermögen einerseits geometrische Verwerfungen sensorisch zu erfassen und durch aktorisches Einleiten entsprechender Gegenverformungen das Flächensubstrat in einer gewünschten vorgegebenen Form zu belassen.

In einem besonders bevorzugten Ausführungsbeispiel werden aus piezokeramischen Material bestehende Sensorschichten auf die Oberfläche eines Flächensubstrates appliziert und vermögen somit bereits geringste Flächenverwerfungen zu detektieren. Die seitens der piezokeramischen Sensorschicht generierten Sensorsignale werden zur weiteren Verarbeitung einer ebenfalls an dem Flächensubstrat applizierten oder in dem Flächensubstrat integrierten Signaleinheit zugeführt, in der Aktorsignale generiert werden, die zur Induzierung entsprechender Gegenverformungen an die ebenfalls aus piezokeramischem Material gefertigten schichtförmig ausgebildeten Aktorelemente geleitet werden.

Im Falle eines als Mikrochip ausgebildeten Flächenelementes lassen sich zur elektrischen Energieversorgung der sensorisch und aktorisch wirkenden Schichten mikrochipinteme Leiterstrukturen nutzen. Ebenso können die mikrochipintemen Rechenleistungen dafür eingesetzt werden, um entsprechende Aktorsignale auf der Grundlage der Sensorsignale zu generieren.

Die Betriebssicherheit von mikrostrukturierten Flächensubstraten, bspw. von Mikrochips, in denen hochintegrierte elektrische Schaltkreise implementiert sind, kann erfindungsgemäß dadurch verbessert werden, indem durch einen aktiven Regelkreis aktuelle geometrische Verwerfungen innerhalb des Flächensubstrates detektiert und entsprechend aktiv durch Einleiten von entsprechenden Gegenverformungen unterdrückt werden. Auf diese Weise lässt sich auch das thermisch begrenzte Einsatzspektrum für Flächensubstrat-gebundene Mikrosysteme erheblich erweitern, zumal thermisch bedingte Verwerfungen innerhalb des Flächensubstrates durch aktive Unterdrückung nicht mehr zum Ausfall des Mikrosystems führen können. Zudem stellen fertigungsbedingte, durch Eigenspannungen hervorgerufene Verformungen keinerlei Probleme in Bezug auf eine erwünschte Systemzuverlässigkeit und lange Lebensdauer bei derartigen flächensubstratgebundenen Mikrosysteme dar.

Neben der bereits erwähnten Chiptechnologie, die durch die lösungsgemäße Maßnahme einen erheblichen Systemvorteil erfährt, zumal die Applikation bzw. Integration sensorisch und aktorisch wirkender Schichten an dem Chip unter Nutzung der ohnehin auf dem Chip vorgesehenen Mikroelektronik zu Zwecken der elektrischen Energieversorgung sowie der Bereitstellung von Rechenleistung zur Auswertung der Sensorsignale und Generierung von Aktorsignalen vorgenommen werden kann, eröffnen sich auch für nicht mit elektrischen Baugruppen konfektionierte Flächensubstrate die mit der lösungsgemäßen Maßnahme verbundenen Vorteile. Beispielsweise werden Flächensubstrate einseitig mit hochreflektierenden Oberflächen vergütet, die in Dimensionen der Mikrosystemtechnik einzeln oder in einer arrayförmigen Anordnung als Mikrospiegel zur gezielten Lichtlenkung dienen. Um hohe und gleich bleibende Abbildungsqualitäten derartiger Mikrospiegel zu gewährleisten, sind die der Spiegeloberfläche abgewandten Rückseiten der Mikrospiegel mit wenigstens einer sensorischen und aktorischen Schicht zur aktiven Formerhaltung der Mikrospiegel vorgesehen, unabhängige davon ob es sich um plane oder gekrümmte Spiegeloberflächen handelt.

Wie bereits vorstehend erwähnt eignet sich besonders gut der Einsatz piezokeramischer Werkstoffe als sensorische und aktorische Schichten, jedoch können je nach Einsatzzweck und Flächensubstrat auch andere multifunktionale Werkstoffe eingesetzt werden, wie bspw. bleifreie Piezokeramik, elektrostriktive Keramik, Formgedächtnislegierung, Formgedächtnispolymer, PVDF (Polyvinylidenfluorid), magnetostriktive Legierung oder Bi-Metall.

### Kurze Beschreibung der Erfindung

Die Erfindung wird nachstehend ohne Beschränkung des allgemeinen Erfindungsgedankens anhand von Ausführungsbeispielen unter Bezugnahme auf die Zeichnungen exemplarisch beschrieben. Es zeigen:
- Fig. 1: Draufsicht auf eine Oberfläche eines Flächensubstrats sowie
- Fig. 2: Längsschnitt durch ein Flächensubstrat mit aktorischen und sensorischen Schichten.

### Wege zur Ausführung der Erfindung, gewerbliche Verwendbarkeit

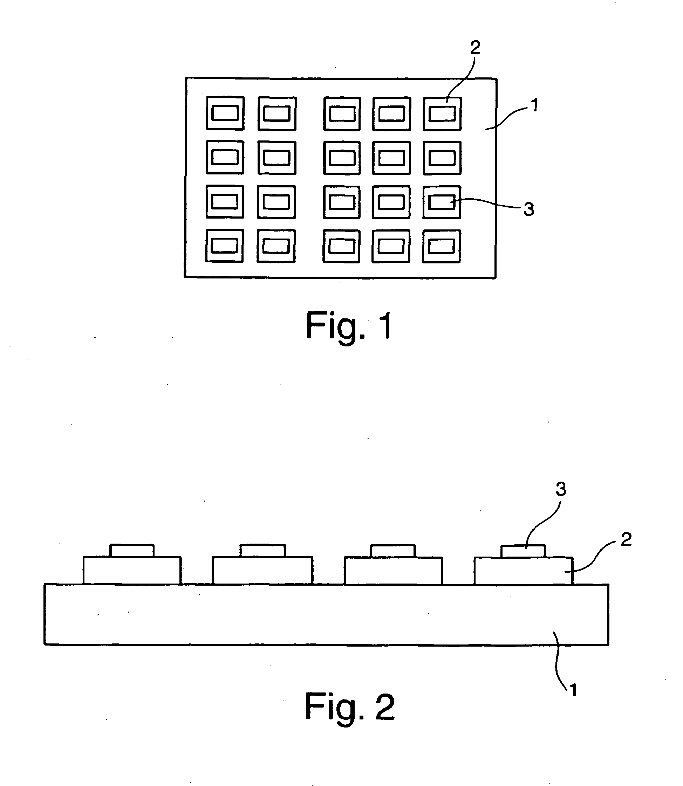

Figur 1 zeigt eine Draufsicht auf eine ebene Oberfläche eines Flächensubstrates 1, auf der eine Vielzahl einzelner Sensor-Aktorelemente aufgebracht ist. Figur 2 zeigt einen Längsschnitt durch das in Figur 1 dargestellte Flächensubstrat. Unmittelbar auf der Oberfläche des Flächensubstrats 1 befinden sich in einer regelmäßigen Anordnung flächig verteilt piezoelektrische Keramikschichtabscheidungen, die als aktorische Schichten 2 dienen, auf deren, dem Flächensubstrat 1 abgewandten Oberfläche jeweils eine sensorische Schicht 3 vorgesehen ist, die gleichfalls aus einer Piezokeramik besteht. Wird das Flächensubstrat 1 aufgrund thermisch induzierter Spannungen verformt, so verformen sich automatisch ebenfalls die sensorischen Schichten 3, die aufgrund der piezoelektrischen Materialcharakteristik eine Ladungsverschiebung erfahren und eine technisch erfassbare elektrische Spannung erzeugen, die mit Hilfe einer nicht in der Figur 1 dargestellten Signalauswerteeinheit erfasst wird und aufgrund derer entsprechende Ansteuersignale für die unmittelbar auf der Flächensubstratoberfläche abgeschiedenen aktorischen Schichten 2 dienen. Werden die aktorischen Schichten 2 mit einer elektrischen Spannung beaufschlagt, so erfolgt umgekehrt zum Wirkprinzip der sensorischen Schicht eine in Abhängigkeit der an die aktorische Schicht 2 applizierte elektrische Spannung proportionale Verformung der aktorischen Schicht 2, wodurch das Flächensubstrat 1 zumindest im Bereich der aktorische Schichte 2, aufgrund der innigen Verbindung zwischen der aktorischen Schicht 2 und dem Flächensubstrat 1 deformiert wird. Die Deformation erfolgt unter Maßgabe der Reduzierung von durch innere Spannungen innerhalb des Flächensubstrates 1 hervorgerufenen Verformungen, mit dem Ziel einer möglichst unveränderlichen Formerhaltung des Flächensubstrates 1.

Das Flächensubstrat gemäß dem Ausführungsbeispiel in Figur 1 und 2 stellt ein Mikrochip dar, der über eine Vielzahl einzelner Schichten und Prozessorstrukturen verfügt. Ebenfalls ist es möglich, die Maßnahme an der Rückseite eines Mikrospiegelsystems anzubringen, um eine vorgegebene Spiegelform trotz sich ändernder Umgebungstemperaturen unverändert beizubehalten.

### Bezugszeichenliste

- 1: Flächensubstrat
- 2: aktorische Schicht, Aktor
- 3: Sensorische Schicht, Sensor

## Patentansprüche

1. Flächensubstrat mit einer innerhalb des Flächensubstrats integrierten oder an einer Oberfläche des Flächensubstrats applizierten elektrisch leitenden Struktur und/oder einer technisch vergüteten Oberfläche, bei dem wenigstens ein Sensor in dem Flächensubstrat integriert oder an einer Oberfläche des Flächensubstrates appliziert ist, der in Abhängigkeit von innerhalb des Flächensubstrats auftretenden mechanischen Spannungen Sensorsignale generiert, und bei dem wenigstens ein Aktor in dem Flächensubstrat integriert oder an der Oberfläche des Flächensubstrats appliziert ist, der bei Aktivierung das Flächensubstrat mechanisch zu deformieren vermag, wobei eine mit dem wenigstens einen Sensor und dem wenigstens einen Aktor verbundene Signaleinheit vorgesehen ist, die auf der Grundlage der Sensorsignale Aktorsignale zur Aktivierung des Aktors generiert, so dass innerhalb des Flächensubstrats auftretende Verformungen reduziert werden,
**dadurch gekennzeichnet, dass** der wenigstens eine Sensor und Aktor schichtförmig ausgebildet sind und wenigstens in Teilbereichen aus einem multifunktionalen Material bestehen,
dass das Flächensubstrat ein Mikrochip mit ein- oder mehrlagigem Aufbau ist, und dass die Signaleinheit Teil des Chips ist und die zur Signalgenerierung erforderliche Logik durch die im Chip immanente Rechenleistung abgebildet wird.

2. Flächensubstrat nach Anspruch 1,
**dadurch gekennzeichnet, dass** zur elektrischen Energieversorgung der wenigstens eine Aktor mit dem Chip verbunden ist.

3. Flächensubstrat nach Anspruch 1 oder 2,
**dadurch gekennzeichnet, dass** der multifunktionale Werkstoff ein Werkstoff aus einer der nachfolgenden Werkstoffklassen ist: Piezo-Keramik, bleifreie Piezokeramik, elektrostriktive Keramik, Formgedächtnislegierung, Formgedächtnispolymer, PVDF (Polyvinylidenfluorid), magnetostriktive Legierung oder Bi-Metall.

## Claims

1. A planar substrate with an electrically conducting structure integrated within the planar substrate, or applied to a surface of the planar substrate, and/or a surface with a technical coating, in which at least one sensor is integrated in the planar substrate, or is applied to a surface of the planar substrate, which generates sensor signals as a function of mechanical stresses occurring within the planar substrate, and in which at least one actuator is integrated in the planar substrate, or is applied to the surface of the planar substrate, which when activated is able to deform the planar substrate mechanically, wherein a signal unit is provided, which is connected with the at least one sensor and the at least one actuator, and which on the basis of the sensor signals generates actuator signals for purposes of activating the actuator, so that deformations occurring within the planar substrate are reduced, **characterised in that**, the at least one sensor and actuator are designed in the form of a layer, and at least in sub-regions consist of a multi-functional material, **in that** the planar substrate is a microchip with a single-layer or multi-layer structure, and **in that** the signal unit is part of the chip, and the logic required for purposes of signal generation is reproduced by means of the computing power immanent in the chip.

2. The planar substrate in accordance with Claim 1, **characterised in that**, for purposes of electrical energy supply the at least one actuator is connected with the chip.

3. The planar substrate in accordance with Claim 1 or 2, **characterised in that**, the multi-functional material is a material from one of the following material classes: piezoceramic, lead-free piezoceramic, electrostrictive ceramic, shape memory alloy, shape memory polymer, PVDF (polyvinylidene fluoride), magnetostrictive alloy, or bi-metal.

## Revendications

1. Substrat plat avec une structure électroconductrice intégrée à l'intérieur du substrat plat ou appliquée sur une surface du substrat plat et/ou une surface techniquement améliorée, avec lequel au moins un capteur est intégré dans le substrat plat ou bien est appliqué sur une surface du substrat plat, lequel génère des signaux de détection en fonction de tensions mécaniques survenant à l'intérieur du substrat plat, et avec lequel au moins un actionneur est intégré dans le substrat plat ou bien est appliqué sur la surface du substrat plat, lequel lorsqu'il est activé, est capable de déformer mécaniquement le substrat plat, une unité de génération de signaux reliée à cet au moins un capteur et cet au moins un actionneur étant prévue, laquelle génère sur la base des signaux de détection des signaux d'actionnement pour l'activation de l'actionneur, de sorte que des déformation apparaissant à l'intérieur du substrat plat soient réduites, **caractérisé en ce que** cet au moins un capteur et cet au moins un actionneur sont réalisés en forme de couches et se composent au moins dans des zones partielles d'un matériau multifonctionnel, **en ce que** le substrat plat est une micro-puce d'une structure mono ou multicouches, et **en ce que** l'unité de génération de signaux est une partie de la puce et **en ce que** la logique nécessaire pour la génération des signaux est formée par la puissance de calcul immanente dans la puce.

2. Substrat plat selon la revendication 1, **caractérisé en ce que** pour l'alimentation électrique, cet au moins un actionneur est relié à la puce.

3. Substrat plat selon la revendication 1 ou 2, **caractérisé en ce que** le matériau multifonctionnel est un matériau de l'une des classes de matériaux suivantes : piézocéramique, piézocéramique sans plomb, céramique électrostrictive, alliage à mémoire des formes, polymère à mémoire des formes, PVDF (fluorure de polyvinylidène), alliage magnétostrictif ou bimétal.
